(19) Europäisches Patentamt
European Patent Office
Office européen des brevets

(11) **EP 2 230 528 B1**

(12) **FASCICULE DE BREVET EUROPEEN**

(45) Date de publication et mention
de la délivrance du brevet:
**09.05.2012 Bulletin 2012/19**

(51) Int Cl.:
**G01R 31/317** *(2006.01)*

(21) Numéro de dépôt: **10156773.3**

(22) Date de dépôt: **17.03.2010**

(54) **Procédé de test intégré d'une ligne.**

Integriertes Testverfahren einer Leitung

Integrated test method for a line.

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **17.03.2009 FR 0901234**

(43) Date de publication de la demande:
**22.09.2010 Bulletin 2010/38**

(73) Titulaire: **Thales**
**92200 Neuilly Sur Seine (FR)**

(72) Inventeur: **Bouyat, Stéphane**
**86130, SAINT CYR (FR)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A1-97/14974        WO-A1-99/40448
US-A1- 2004 123 195     US-B1- 7 406 642**

**Description**

Le domaine de l'invention est celui des procédés de tests intégrés BIT (de l'Anglo saxon "built-in-tests") aussi appelés autotests de lignes comprenant une broche d'entrée/sortie d'un circuit logique programmable connectée à au moins un élément périphérique. Par procédé d'autotest, on entend que la ligne est apte à mettre en oeuvre le procédé de test apte à détecter une défaillance de la ligne et éventuellement à identifier l'origine de la défaillance de cette ligne.

Ces tests peuvent être réalisés en phase de production des équipements comprenant les lignes à tester ou bien en phase opérationnelle (en fonctionnement ou en début de fonctionnement) des lignes à tester.

On connaît des procédés de tests de lignes qui consistent à appliquer des signaux logiques sur une première broche de sortie d'un premier circuit et à relever les niveaux logiques sur la broche d'entrée du second circuit qui est connectée à la première broche de sortie. Les niveaux logiques mesurés sur la broche d'entrée du second composant sont comparés à des niveaux attendus. Si ces niveaux diffèrent, la ligne est considérée comme défectueuse. Cependant ce type de procédés est coûteux car il nécessite un équipement lourd de test. En effet, il est nécessaire d'intégrer sur la ligne à tester un élément permettant de générer les signaux logiques de sortie, un élément permettant de mesurer le niveau logique d'entrée ainsi qu'un élément de synchronisation des broches d'entrée et de sortie du premier et du second circuit de sorte à attribuer la réponse de la broche d'entrée à un signal logique appliqué sur la broche de sortie. On appelle fausse alarme, la détection d'une défaillance de la ligne testée alors même que la ligne n'est pas défaillante. Les procédés décrits précédemment présentent un taux de fausses alarmes élevé. Il est en effet possible de détecter une défaillance de la ligne qui est due, en réalité, à une défaillance d'un des éléments de l'équipement de test.

Du document US7, 406, 642, on connaît également un procédé de test JTAG. Le procédé de test JTAG est un test dans lequel on injecte un signal de test en entrée d'un circuit et on relève le niveau logique en sortie.

L'invention a pour but de proposer un procédé de test de ligne intégré qui soit bon marché, et qui présente un taux de fausses alarmes restreint. Un autre but de l'invention est de proposer un procédé de test de ligne permettant d'identifier, avec de bonnes performances, l'origine des défaillances détectées. L'invention a également pour but de proposer une ligne apte à mettre en oeuvre le procédé selon l'invention.

L'invention a pour objet un procédé de test d'une ligne comprenant une broche d'entrée/sortie d'un circuit logique programmable, ladite ligne comprenant au moins une ligne individuelle s'étendant depuis la broche d'entrée/sortie jusqu'à un élément périphérique, ladite broche d'entrée/sortie étant apte à être, soit dans un niveau logique haut, soit dans un niveau logique bas opposé au niveau logique haut, ledit procédé comprenant les étapes suivantes :

- entre un instant initial de pilotage et un instant final de pilotage, une étape de pilotage de la broche d'entrée/sortie dans laquelle on applique une tension de pilotage aux bornes de la broche d'entrée/sortie, ledit procédé comprenant en outre les étapes suivantes :
- à partir de l'instant final de pilotage, une étape de mesure du niveau de la broche d'entrée/sortie pendant laquelle la broche n'est plus pilotée et pendant laquelle on relève un niveau logique mesuré de la broche d'entrée/sortie à au moins un instant de mesure,
- on compare le(s) niveau(x) logique(s) mesuré(s) à l'(aux) instant(s) de mesure (respectifs) avec le(s) niveau(x) logique(s) théorique(s) dans le(s)quel(s) devrait être la broche d'entrée/sortie à (aux) instant(s) de mesure (respectifs) en l'absence de défaillance de la ligne,
- lorsqu'au moins un niveau logique mesuré à un instant de mesure diffère du niveau logique théorique audit instant de mesure, une défaillance de la ligne est détectée.

Le procédé selon l'invention peut présenter en outre, une ou plusieurs des caractéristiques suivantes prises ensemble ou séparément :

- on définit que lorsque la broche d'entrée/sortie n'est pas pilotée:

  - elle est dans le niveau logique haut lorsque la tension à ses bornes est supérieure à une tension d'entrée minimale de niveau haut et dans le niveau logique bas lorsque la tension à ses bornes est inférieure à une tension d'entrée maximale de niveau bas,
  - lorsqu'elle est en régime permanent c'est-à-dire lorsqu'une tension permanente est appliquée à ses bornes, elle est dans un premier niveau logique dont la valeur dépend de la valeur de la tension permanente, et on choisit la valeur de la tension de pilotage, appliquée pendant la phase de pilotage du procédé de test, de sorte à mettre la broche dans un deuxième niveau logique, opposé au premier niveau logique, lors de la phase de mesure, la ligne forme un circuit RC de sorte que la tension théorique aux bornes de la broche d'entrée/sortie évolue de la tension de pilotage vers la tension permanente avec une constante de temps théorique d'absence de pilotage, on relève le niveau logique mesuré de la broche d'entrée/sortie à au moins un instant de mesure auquel la tension théorique de la broche n'est pas comprise entre la tension d'entrée maximale de niveau bas et la tension d'entrée minimale de niveau haut,

- la constante de temps théorique d'absence de pilotage du circuit RC est égale au produit de la résistance théorique et de la capacité théorique du circuit RC,
- la résistance théorique et la capacité théorique du circuit RC sont soit respectivement égales à la résistance et à la capacité de la ligne, en l'absence de pilotage et de défaillance de la ligne, soit respectivement égales à une approximation de ces valeurs,
- on relève le niveau logique mesuré à au moins un instant de mesure auquel le niveau logique théorique est le second niveau logique et à au moins un instant de mesure auquel le niveau logique théorique est égal au premier niveau logique théorique,
- on relève le niveau logique mesuré à au moins deux instants de mesure auxquels le niveau logique théorique est le second niveau logique et à au moins deux instants de mesure auxquels le niveau logique théorique est égal au premier niveau logique théorique,
- lorsque la défaillance est détectée, il comprend en outre une étape d'identification de l'origine de la défaillance en fonction des niveaux logiques mesurés et des niveaux théoriques aux instants de mesure respectifs,
- on relève le niveau logique de la broche à un premier instant puis à un second instant auxquels le niveau logique théorique est le second niveau logique puis à un troisième instant et à un quatrième instant auxquels le niveau logique théorique est le premier niveau logique théorique et, si les niveaux mesurés logiques mesurés évoluent du second niveau logique vers le premier niveau logique avec du retard, respectivement de l'avance, par rapport aux niveaux logiques théoriques, on attribue l'origine de la défaillance au fait que la seconde constante de temps réelle de la ligne est supérieure, respectivement inférieure à la constante de temps théorique de la ligne,
- on relève le niveau logique de la broche à un premier instant puis à un second instant auxquels le niveau logique théorique est le second niveau logique puis à un troisième instant et à un quatrième instant auxquels le niveau logique théorique est le premier niveau logique théorique et :

    - lorsque le premier niveau logique est le niveau logique haut, si aux quatre instants de mesures, on relève le niveau logique haut, on attribue l'origine de la défaillance à un court-circuit vers un potentiel supérieur à la tension d'entrée minimale de niveau haut,
    - lorsque le premier niveau logique est le niveau logique bas, si aux quatre instants de mesures, on relève le niveau logique bas, on attribue l'origine de la défaillance à un court-circuit vers un potentiel inférieur à la tension d'entrée maximale de niveau bas.

- il comprend en outre une étape de correction de la défaillance,
- le premier niveau logique est connu,
- préalablement à la phase de pilotage, on procède à une phase de détermination du premier niveau logique dans laquelle la broche d'entrée/sortie n'est pas pilotée et dans laquelle on mesure le niveau logique de la broche d'entrée/sortie, le niveau logique mesuré étant considéré comme étant égal au premier niveau logique.

L'invention a également pour objet une ligne comprenant une broche d'entrée/sortie d'un circuit logique programmable, un contrôleur apte à appliquer une tension de pilotage aux bornes de la broche d'entrée/sortie et à relever le niveau logique de la broche d'entrée/sortie, la ligne comprenant en outre au moins une ligne individuelle s'étendant depuis la broche d'entrée/sortie jusqu'à un élément périphérique, ladite ligne individuelle comprenant :

- une première résistance, dont la valeur est une valeur de première résistance, disposée en série avec la broche d'entrée/sortie et connectée, d'une part, à un premier noeud et d'autre part, à la broche d'entrée/sortie,
- une première capacité, dont la valeur est la valeur de première capacité, disposée en parallèle avec la broche d'entrée/sortie et connectée, d'une part, au premier noeud et d'autre part, à un potentiel de première capacité,
- un second noeud connecté à l'élément périphérique et à un câblage,
- une seconde résistance, connectée à un potentiel de deuxième résistance et au premier noeud par l'intermédiaire du câblage,
- une seconde capacité connectée au second noeud et à la masse.

La ligne selon l'invention peut présenter en outre, une ou plusieurs des caractéristiques suivantes prises ensemble ou séparément :

- la seconde résistance comprend une résistance de rappel vers le haut, le potentiel de premier condensateur est nul, le potentiel de deuxième résistance est supérieur ou égal à la tension d'entrée minimale de niveau haut de sorte que le premier état logique est le niveau haut,

- la seconde résistance comprend une résistance de rappel vers le bas, le potentiel de premier condensateur est supérieur ou égal à la tension d'entrée minimale de niveau haut, le potentiel de deuxième résistance est nul de sorte que le premier état logique est le niveau bas,
- elle comprend un moyen de détection de l'origine d'une défaillance et éventuellement un moyen de correction de la défaillance.

Le procédé selon l'invention présente l'avantage de permettre de tester indifféremment et avec la même topologie, toute ligne d'entrée ou de sortie du circuit logique programmable.

Le procédé selon l'invention présente les avantages d'être peu coûteux et de détecter les déficiences d'une ligne avec un faible taux de fausses alarmes. La mise en oeuvre du procédé ne nécessite pas d'ajouter des composants spécifiques au test en dehors de composants passifs du type résistance ou capacité. Cependant, ces derniers composants sont généralement présents sur la ligne à tester et même s'ils sont ajoutés spécifiquement pour la mise en oeuvre du procédé selon l'invention ils ne dégradent que de façon minime le taux de fausse alarme car ce sont des composants passifs (résistances et/ou capacités). De plus, ces composants sont bon marché. De plus, étant donné que l'on commande la broche d'entrée/sortie du circuit logique programmable et que l'on relève le niveau logique de cette même broche, il n'est pas nécessaire d'intégrer un élément de synchronisation entre l'élément extérieur et la broche d'entrée/sortie, spécifiquement pour le test.

Le procédé d'autotest selon l'invention permet d'identifier avec de bonnes performances l'origine d'une défaillance de la ligne et éventuellement de corriger cette défaillance.

Le procédé selon l'invention peut en outre servir à la fois en production et en opérationnel car il ne nécessite pas d'équipement extérieur à la ligne.

D'autres caractéristiques et avantages de l'invention apparaîtront à la lecture de la description détaillée qui suit, faite à titre d'exemple non limitatif et en référence aux dessins annexés dans lesquels :

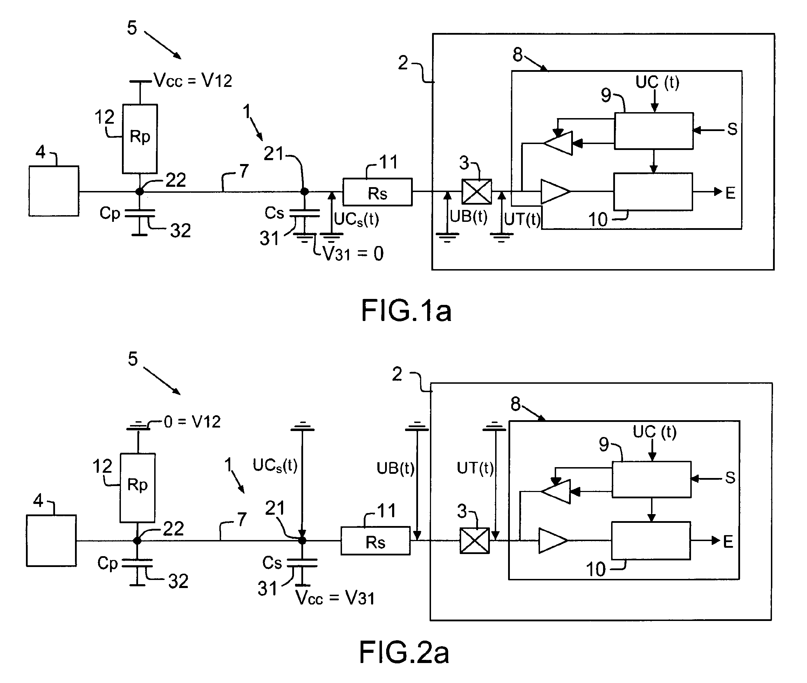

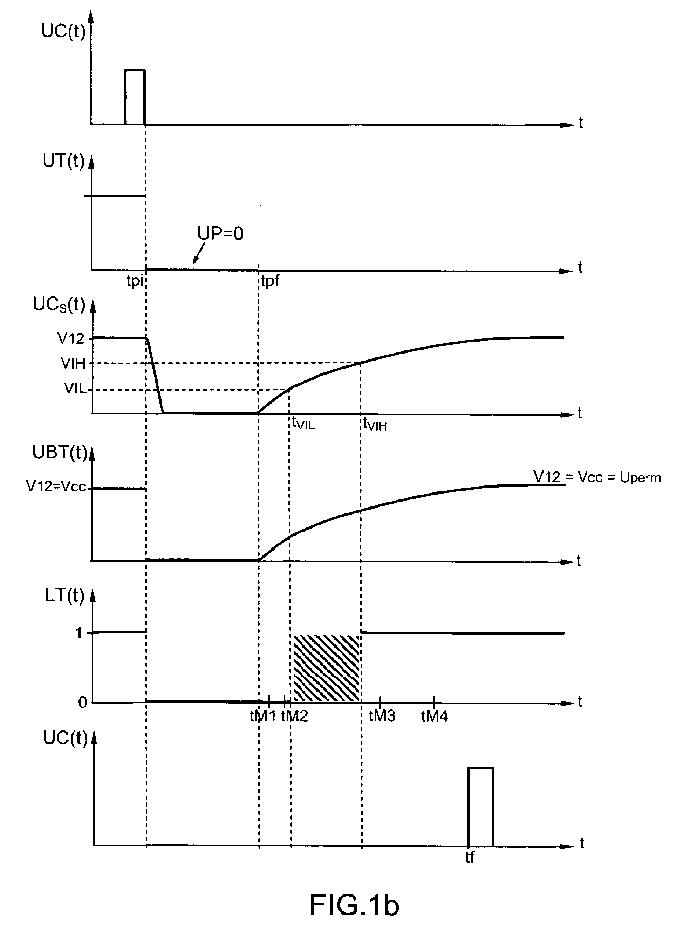

- la figure 1a représente schématiquement une ligne selon un premier mode de réalisation et la figure 1b représente des chronogrammes représentant, pendant la mise en oeuvre du procédé selon le premier mode de réalisation, l'évolution dans le temps du signal reçu par le contrôleur UC(t), du signal de test UT(t), de la tension théorique aux bornes du premier condensateur $UC_s(t)$, de la tension théorique aux bornes de la broche d'entrée/sortie UBT(t), du niveau logique théorique LT(t) de la broche d'entrée/sortie,

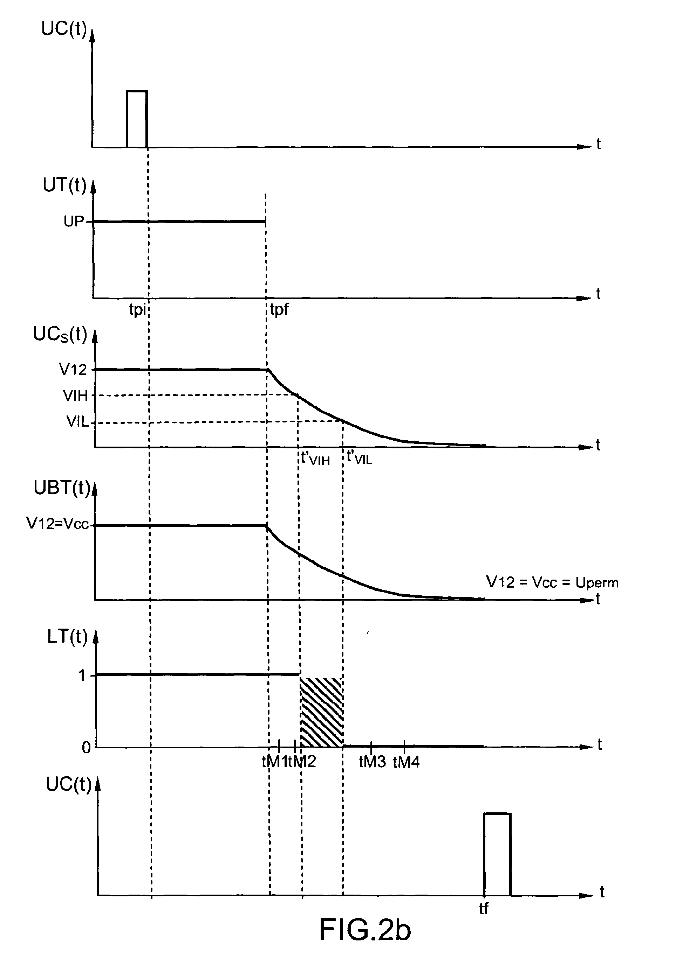

- la figure 2a représente schématiquement une ligne selon un deuxième mode de réalisation et la figure 2b représente des chronogrammes représentant, pendant la mise en oeuvre du procédé selon le deuxième mode de réalisation, l'évolution dans le temps du signal reçu par le contrôleur UC(t), du signal de test UT(t), de la tension théorique aux bornes du premier condensateur UCs(t), de la tension théorique aux bornes de la broche d'entrée/sortie UBT(t), du niveau logique théorique LT(t) de la broche d'entrée/sortie,

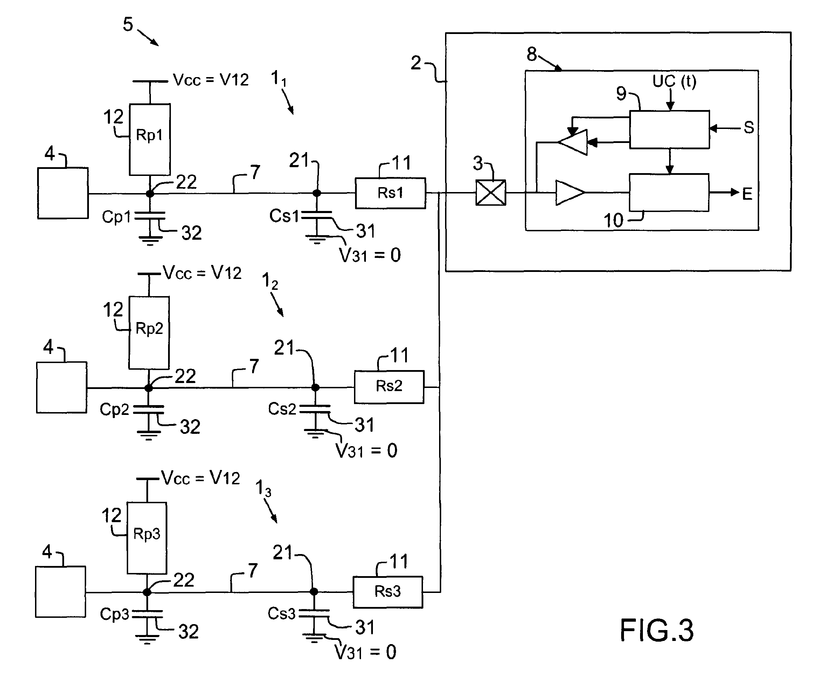

- la figure 3 représente schématiquement une ligne comprenant plusieurs lignes individuelles.

D'une figure à l'autre, les mêmes éléments sont repérés par les mêmes références.

Sur la figure 1a, on a représenté une ligne 5 selon un premier mode de réalisation de l'invention. Cette ligne comprend une broche d'entrée/sortie 3 d'un circuit logique programmable 2 ainsi qu'un élément périphérique 4. La ligne 5 comprend en outre un contrôleur 8, qui est relié à la broche d'entrée/sortie 3 du circuit logique programmable 2. La ligne s'étendant de l'élément périphérique 4 à la broche d'entrée/sortie 3 est une ligne individuelle 1.

Le circuit logique programmable est, par exemple, du type FPGA (de l'anglo-saxon "Field Programmable Gate Array") et présente une ou plusieurs broches d'entrée/sortie 3. L'élément périphérique est, par exemple, un circuit logique programmable ou un circuit comprenant un interrupteur ou un transistor relié à la masse ou bien un autre type de circuit intégré.

La ligne individuelle 1 comprend en outre un câblage 7 reliant électriquement la broche d'entrée/sortie 3 à l'élément périphérique 4 ainsi que des résistances et des capacités qui seront décrites ultérieurement.

La broche d'entrée/sortie 3 est apte à être soit dans un niveau logique haut (niveau "1"), soit dans un niveau logique bas (niveau "0"). Ces deux niveaux logiques sont dits des niveaux logiques opposés l'un par rapport à l'autre.

Dans la suite du texte, par relié ou connecté on entend relié électriquement. La ligne individuelle 1 comprend une première résistance 11, de valeur de première résistance Rs qui est disposée en série avec la broche d'entrée/sortie 3 et qui est connectée, d'une part, directement à un premier noeud 21, et d'autre part, directement à la broche d'entrée/sortie 3. Par directement, on entend que la résistance est connectée à la broche d'entrée/sortie 3 par l'intermédiaire d'un câblage de résistance et de capacité négligeables ou bien la résistance est la résistance du câblage qui relie le premier noeud 21 à la broche d'entrée/sortie 3. En variante, le premier noeud 21 n'est pas relié directement à la broche d'entrée/sortie 3.

La ligne individuelle 1 comprend également une première capacité 31, de valeur de première capacité Cs qui est disposée en parallèle avec la broche d'entrée/sortie 3 et est connectée, d'une part, directement au premier noeud 21, et d'autre part, à un potentiel de première capacité V31. La tension entre le premier noeud 21 et la masse est appelée tension aux bornes du premier condensateur $UC_s$. Dans la ligne selon le premier mode de réalisation de l'invention, le potentiel de première capacité V31 est nul, la première capacité est reliée à la masse. Un deuxième noeud 22 est relié au premier noeud 21 par l'intermédiaire du câblage 7.

La ligne individuelle 1 comprend en outre une seconde résistance 12 connectée à un potentiel de seconde résistance V12 et au deuxième noeud 22 par l'intermédiaire du câblage 7 présentant une résistance et une capacité négligeables.

Dans la ligne individuelle 1 selon le premier mode de réalisation, ladite seconde résistance 12 est une résistance disposée en parallèle avec l'élément périphérique 4 et connectée, d'une part, à un potentiel de seconde résistance V12 = Vcc et, d'autre part, directement au second noeud 22. Le potentiel de seconde résistance V12 dont la valeur est égale à Vcc est positif et est supérieure à la tension d'entrée minimale de niveau haut VIH qui sera décrite plus tard. On dit que la seconde résistance 12 qui est une résistance disposée en parallèle avec l'élément périphérique 4 et qui est connecté à un potentiel supérieur à la tension d'entrée minimale de niveau haut VIH est une résistance de rappel vers le niveau logique haut.

La ligne comprend en outre une seconde capacité 32 connectée au second noeud 22 et à la masse.

Sur la figure 2a, on a représenté une ligne selon un second mode de réalisation de l'invention. Les éléments communs à la figure 2a et à la figure 1a sont désignés par les mêmes références numériques et ne seront pas décrits à nouveau.

Dans le second mode de réalisation, le potentiel de seconde résistance V12 est nul, la seconde résistance est reliée à la masse, tandis que le potentiel de première capacité V31 (égal à Vcc) est positif et est supérieur ou égal à la tension d'entrée minimale de niveau haut VIH. La seconde résistance est une résistance de rappel vers le niveau logique bas.

Les résistances et capacités décrites précédemment sont classiquement présentes sur les lignes. Si elles ne sont pas présentes, elles y sont intégrées de manière à pouvoir mettre en oeuvre le procédé de test selon l'invention. Ces résistances et capacités sont soit les résistances et les capacités de câblages, soit des résistances et capacité, en tant que composants, intégrés entre les câblages.

La valeur Rs de la première résistance 11 est, de préférence, négligeable devant la valeur Rp de la seconde résistance 12. Par négligeable, on entend que la valeur Rs de la première résistance est au moins 5 fois plus faible, de préférence 10 fois plus faible, que la valeur Rp de la seconde résistance 12. De préférence, la valeur Cp de la seconde capacité 32 est négligeable devant la valeur Cs de la première capacité 31.

La ligne 5 comprend en outre un contrôleur 8 comprenant un générateur de signal 9 qui est apte, pendant la phase de test, soit à piloter la broche d'entrée/sortie 3, en générant un signal de test UT(t), soit à ne pas piloter cette broche, c'est-à-dire à laisser la broche flottante en ne lui appliquant pas de signal de test. Le contrôleur comprend un moyen de mesure 10, apte à relever l'état de la broche d'entrée/sortie 3.

En dehors de la phase de test (en fonctionnement nominal), le contrôleur est rendu transparent vis à vis de la logique interne du circuit logique programmable. Par transparent on entend que le contrôleur ne fonctionne pas et que c'est le circuit logique programmable qui pilote la broche d'entrée/sortie ou qui la laisse flottante (le circuit logique transmet directement ses ordres d'entrée E à la broche 3 qui transmet des informations S directement au circuit logique. Tout se passe comme si le contrôleur était inactif.)

On définit un premier niveau logique L1 de la broche d'entrée/sortie 3 qui est soit le niveau logique haut, soit le niveau logique bas. Le premier niveau logique L1 est le niveau dans lequel se trouve la broche lorsque celle-ci est dans un état permanent dans lequel elle n'est pas pilotée. On dit que la broche n'est pas pilotée lorsqu'elle n'est pilotée ni par le circuit logique programmable 2 ni par le générateur de signal 9.

Le niveau logique est défini par la valeur de la tension permanente Uperm aux bornes de la broche 3 en régime permanent. Lorsque la broche d'entrée/sortie 3 se comporte comme une entrée (lorsqu'elle n'est pas pilotée), elle est dans le niveau logique haut lorsque la tension de la broche UB(t) est supérieure à une tension d'entrée minimale de niveau haut VIH et dans le niveau bas lorsque la tension de la broche d'entrée/sortie 3 est inférieure à la tension d'entrée maximale de niveau bas VIL.

Dans la ligne selon le premier mode de réalisation représentée sur la figure 1 la broche d'entrée/sortie 3 est configurée en sortie en mode de fonctionnement nominal (l'élément périphérique est une entrée). Lorsqu'on arrête le pilotage de la broche et en l'absence de défaillance de la ligne, la broche se comporte comme une entrée (haute impédance), le premier condensateur passe par une période de transition dans lequel il se charge jusqu'à ce que la tension à ses bornes $UC_s(t)$ atteigne la tension de régime permanent Uperm qui est égale au potentiel de la seconde résistance V12 supérieur à VIH. Comme en l'absence de pilotage, aucun courant ne circule dans la première résistance, la tension aux bornes de la broche est égale à la tension aux bornes du premier condensateur. Le premier niveau logique L1 est alors le niveau haut.

En variante, la ligne selon le premier mode de réalisation est configurée en entrée en mode de fonctionnement nominal et le niveau logique nominal imposé par l'élément périphérique (sortie) est le niveau haut car il impose aux bornes de la broche, une tension égale au potentiel de seconde résistance qui est supérieur à VIH. Par exemple, l'élément périphérique est un interrupteur ou un transistor ouvert en mode nominal, relié d'une part au second noeud 22 et d'autre part à la masse. En variante, l'élément périphérique est une entrée logique du type booléen.

Dans la ligne selon le second mode de réalisation représentée sur la figure 2a, le premier niveau logique L1 est le niveau bas lorsque, par exemple, la broche d'entrée/sortie 3 est configurée en sortie en mode nominal et son niveau logique est le niveau bas. Par exemple, l'élément périphérique est un interrupteur ou un transistor, fermé en mode nominal, relié d'une part au second noeud 22 et d'autre part à la masse.

On va maintenant décrire le procédé de test selon l'invention.

Le procédé de test de la ligne 5 consiste à détecter les défaillances de la ligne, éventuellement à identifier l'origine de la défaillance et éventuellement à corriger la défaillance détectée.

Sur les figures 1b et 2b, on a représenté, pour le procédé selon un premier mode de réalisation et respectivement un deuxième mode de réalisation, des chronogrammes représentant l'évolution dans le temps, du signal reçu par le contrôleur 8 UC(t), du signal de test UT(t), de la tension théorique aux bornes du premier condensateur $UC_s(t)$, de la tension théorique aux bornes de la broche d'entrée/sortie UBT(t), du niveau logique théorique LT(t) de la broche d'entrée/sortie 3. La tension théorique aux bornes de la broche d'entrée/sortie 3 est la différence de tension entre la tension de la broche et la masse.

Par un potentiel théorique, on entend ce que devrait être le potentiel en l'absence de défaillance de la ligne.

Dans les exemples de procédés représentés sur les figure 1b et 2b, la tension théorique de la broche et la tension aux bornes du premier condensateur sont égales au potentiel de seconde résistance V12(t) et l'état de la broche (et l'état théorique) est le niveau haut, avant le test. Le procédé de test qui est décrit ci-dessous est indépendant de ces valeurs.

Tout d'abord, comme visible sur les figures 1b et 2b, le générateur de signal 9 reçoit un signal de lancement de test UC(t), par exemple, sous forme d'un créneau de tension. Le générateur de signal 9 génère un signal de test UT (t) qui est un créneau de tension de valeur égale à une tension de pilotage UP, appliqué entre un instant initial de pilotage tpi et un instant final de pilotage tpf sur la broche d'entrée/sortie 3. La tension théorique aux bornes de la broche UBT (t) entre l'instant initial de pilotage tpi et l'instant final de pilotage tpf est égale à la tension de pilotage UP.

Le procédé selon le premier mode de réalisation s'applique aux et est mis en oeuvre par des lignes dont le premier niveau logique est le niveau haut. Dans ce mode de réalisation, la tension de pilotage UP est nulle, comme visible sur la figure 1b, de sorte à mettre la broche dans le niveau logique bas. La tension de pilotage est choisie de manière à mettre la broche 3 dans le second état (opposé au premier état), elle est donc inférieure ou égale à une tension de sortie maximale de niveau bas VOL en dessous de laquelle la broche est dans le niveau bas en mode sortie.

Entre l'instant initial de pilotage tpi et l'instant final de pilotage tpf, la tension théorique aux bornes du premier condensateur $UC_s$ évolue vers la tension de pilotage UP avec une constante de temps théorique de pilotage τp égale à :

$$\tau p = Cs*Rs$$

Avantageusement, on applique la tension de test UT(t) pendant une durée au moins 5 fois égale à la constante de temps théorique de pilotage de sorte que la tension théorique aux bornes du premier condensateur $UC_s$ évolue jusqu'à la tension de pilotage pendant la phase de pilotage.

A l'instant final de pilotage, le générateur de séquence 9 cesse de piloter la première broche d'entrée/sortie 3 jusqu'à la fin du test, c'est une phase de mesure. Le test s'arrête lorsqu'il reçoit un second signal de test à un instant final de test tf.

Pendant la phase de mesure, la broche d'entrée/sortie 3 qui n'est pas pilotée se comporte alors comme entrée (haute impédance) et la tension théorique à ses bornes UBT(t- tpf) est égale à la tension théorique aux bornes de la première capacité car le courant ne circule pas dans la première résistance 11. La ligne forme alors un circuit RC entre le premier 21 et le second noeud 22. La tension théorique UBT(t-tpf) aux bornes de la broche 3 évolue donc vers la tension de régime permanent Uperm qui est le potentiel de la seconde résistance V12 égal à Vcc avec une constante de temps théorique d'absence de pilotage τnp car le premier condensateur 31 se charge avec la même constante de temps.

La tension théorique UBT(t) de la broche 3 augmente vers la tension théorique de régime permanent Uperm = V12 de la manière suivante en fonction du temps à partir de l'instant final de pilotage tpf :

$$UBT(t\text{-}tpf)=Vcc(1\text{-}e^{-(t\text{-}tpf)/\tau 2})$$

La constante de temps théorique d'absence de pilotage τnp est donnée par la formule suivante :

$$\tau np = R*C$$

où R est la valeur de la résistance théorique du circuit RC et C est la capacité théorique du circuit RC qui sont respectivement égales à la résistance et à la capacité de la ligne pendant la phase d'absence de pilotage et en l'absence de défaillance de la ligne. Lorsque la ligne comprend une seule ligne individuelle 1, la résistance de la ligne en l'absence de pilotage et de défaillance de la ligne est égale à la résistance de la ligne individuelle Ri qui est donnée par la formule suivante :

$$Ri=Rp$$

car la capacité de la ligne ne se charge qu'à travers la seconde résistance.

La valeur de la capacité de la ligne individuelle Ci est donnée par la formule suivante :

$$Ci = Cs + Cp$$

En variante, la résistance théorique R et la capacité théorique C du circuit RC sont des approximations, en d'autres termes des valeurs prises dans des intervalles prédéfinis formés autour de la résistance et de la capacité de la ligne en l'absence de pilotage et de défaillance de la ligne. La taille de l'intervalle dépend de l'incertitude sur ces valeurs. La constante de temps est alors une plage de fréquence formée autour d'une valeur moyenne. Cette variante permet de tenir compte des incertitudes sur et/ou des évolutions des valeurs des résistances et des capacités.

Dans le mode de réalisation représenté sur la figure 3, la ligne comprend une pluralité de lignes individuelles $1_1$, $1_2$, $1_3$ présentant chacune la même configuration que la ligne individuelle 1 représentée sur la figure 1, les lignes individuelles sont placées en étoile autour de la broche 3. La capacité et la résistance de la ligne sont la capacité et la résistance de l'ensemble des lignes individuelles. Dans le cas où chaque ligne individuelle comprend une première résistance Rs1, Rs2, Rs3 et une seconde résistance Rp1, Rp2, Rp3 et une seconde capacité Cs1, Cs2, Cs3 qui est négligeable devant la première capacité Cp1, Cp2, Cp3, la capacité C de la ligne est sensiblement égale à C= Cs1+Cs2+Cs3.

La résistance de ligne R est égale à R= Rp1//Rp2//Rp3
où

$$Rp1//Rp2//Rp3=\{[(Rp1 x Rp2)/(Rp1+Rp2)] x Rp3\}/\{[(Rp1 x Rp2)/(Rp1+Rp2)]+Rp3\}$$

Jusqu'à l'instant de niveau bas tVIL auquel la tension théorique UBT(t-tpf) de la broche d'entrée/sortie 3 est égale à la tension d'entrée maximale de niveau bas VIL, le niveau logique théorique LT de la broche est le niveau bas. Lorsque la tension théorique UBT(t-tpf) de la broche est comprise entre tension d'entrée maximale de niveau bas VIL et la tension d'entrée minimale de niveau haut VIH, le niveau logique de la broche est soit le niveau haut soit le niveau bas mais on ne peut pas définir un niveau logique théorique de la broche, cette zone est hachurée sur les figures 1b et 2b. A partir de l'instant de niveau haut $t_{VIH}$ la tension théorique UBT(t-tpf) de la broche est supérieure ou égale à la tension d'entrée minimale de niveau haut VIH, le niveau logique LT de la broche est le niveau haut.

Le procédé selon le deuxième mode de réalisation s'applique aux lignes dont le premier niveau logique est le niveau bas. Dans ce mode de réalisation, on suit les mêmes étapes que dans le premier mode de réalisation mais la tension de pilotage UP est, comme visible sur la figure 1b, égale à Vcc qui est le potentiel du premier condensateur V31 de sorte à mettre la broche dans le second niveau logique qui est le niveau bas. En réalité, la tension de pilotage est au moins égale à la tension de sortie minimale de niveau haut VOH au dessus de laquelle la broche est dans le niveau haut en mode sortie.

Dans le procédé selon le second mode de réalisation, le premier condensateur 31 se charge (ou reste chargé) pendant la phase de pilotage. Lorsque la première broche d'entrée/sortie 3 est laissée flottante, le premier condensateur se décharge avec une seconde constante de temps théorique d'absence de pilotage τnp. La tension théorique de la broche 3 diminue vers la tension théorique de régime permanent Uperm égale au potentiel de seconde résistance V12 qui est nul, de la manière suivante :

$$UBT(t-tpf)=Vcc*e^{-(t-tpf)/\tau 2}$$

Tant que la tension théorique UBT(t-tpf) de la broche d'entrée/sortie 3 est supérieure à la tension d'entrée minimale de niveau haut VIH (t ≤ $t_{VIH'}$), le niveau logique théorique LT de la broche est le niveau haut, puis lorsque la tension théorique de la broche devient inférieure ou égale à la tension d'entrée maximale de niveau bas VIL (t ≥ $t_{VIL'}$), le niveau théorique de la broche LT est le niveau bas.

Dans un mode préférentiel de réalisation, applicable aux procédés selon les deux modes de réalisation, comme représenté sur les figures 1b et 2b, on relève l'état de la broche à 4 instants successifs, à savoir, un premier tM1 et un deuxième tM2 instants de mesure auxquels le niveau logique théorique est le second niveau logique et à un troisième tM3 et à un quatrième instant tM4 instants de mesure auxquels le niveau logique théorique de la broche à ces instants est le premier niveau logique.

On compare ensuite les niveaux logiques mesurés aux instants de mesure tMi respectifs avec les niveaux logiques théoriques dans lesquels devrait être la broche d'entrée/sortie aux instants de mesure tMi respectifs en l'absence de défaillance de la ligne. Si au moins un niveau logique mesuré à un instant de mesure diffère du niveau logique théorique à ce même instant de mesure, alors une défaillance est détectée.

Dans le premier mode de réalisation, si aux quatre instants de mesure tM1, tM2, tM3, tM4, on mesure le niveau logique 0, cela signifie que les niveaux logiques mesurés aux troisième et quatrième instants de mesure sont respectivement différents des niveaux logiques théoriques au troisième et au quatrième instants de mesure. Cela veut également dire que le niveau réel de la broche reste au second niveau logique pendant la phase de mesure. Autrement dit, la seconde constante de temps réelle est très importante, on attribue l'origine de la défaillance, soit au fait que la ligne est ouverte (la résistance de la ligne tend vers l'infini et donc la constante de temps tend vers l'infini) soit au fait que la ligne est court-circuitée à la masse, par exemple, par une bille de soudure (la capacité de la ligne est nulle, la ligne n'a pas de constante de temps, la broche est dans l'état qui correspond au court-circuit.)

Dans le deuxième mode de réalisation, si aux quatre instants de mesure tM1, tM2, tM3, tM4, on mesure le niveau logique 0, on attribue l'origine de la défaillance au fait que la ligne est court-circuitée à la masse.

Dans le premier mode de réalisation, si les quatre états mesurés correspondent au niveau logique haut, cela veut dire que la ligne présente un court-circuit vers un potentiel positif dont la tension est supérieure à la tension minimale d'entrée ou de sortie de niveau haut.

Dans le deuxième mode de réalisation, si les quatre états mesurés correspondent au niveau logique haut cela veut dire que la ligne présente un court-circuit vers un potentiel positif dont la tension est supérieure à la tension minimale d'entrée ou de sortie de niveau haut ou que le circuit est ouvert.

Dans les deux modes de réalisation, si les niveaux mesurés évoluent du second niveau logique vers le premier niveau logique mais avec du retard ou de l'avance, on attribue l'origine de la défaillance au fait que la seconde constante de temps réelle est différente de la seconde constante de temps théorique.

Par exemple, dans le premier mode de réalisation, si on mesure aux trois premiers instants de mesure le niveau bas et au quatrième instant de mesure, le niveau haut, la constante de temps réelle est alors supérieure à la constante de temps théorique, la résistance de ligne et/ou la capacité de ligne sont supérieures à leurs valeurs théoriques respectives. Dans ce mode de réalisation, si on mesure au premier instant de mesure le niveau bas et aux trois derniers instants de mesure, le niveau haut, la constante de temps réelle est alors inférieure à la constante de temps théorique, la résistance de ligne et/ou la capacité de ligne sont inférieures à leurs valeurs théoriques respectives. Alors, la résistance R de la ligne 5 ou la capacité de la ligne 5 est erronée ou bien il existe un court-circuit entre deux lignes adjacentes qui modifie la résistance ou la capacité de la ligne.

Si les quatre niveaux mesurés aux quatre instants de mesure sont respectivement identiques aux quatre niveaux théoriques aux quatre instants de mesure respectifs, alors on peut conclure avec un bon taux de confiance que la constante de temps réelle de la ligne est égale à la constante de temps théorique et que la ligne ne présente pas de déficience.

En variante, on relève les niveaux logiques à deux instants successifs qui sont un premier instant auquel le premier niveau logique théorique est le premier niveau logique et à un second instant auquel le niveau logique théorique est le second niveau logique. Les conclusions présentent plus d'incertitude que lorsqu'on relève 4 niveaux logiques.

Dans le premier mode de réalisation, si aux instants de mesure on relève le niveau bas, on peut conclure qu'il y a un court-circuit à la masse ou que le circuit est ouvert ou que la constante de temps réelle est plus grande que la constante de temps théorique. Si on relève, le niveau logique haut, aux deux instants de mesure, on peut conclure à un court circuit à l'alimentation de la seconde résistance ou à une constante de temps réelle plus faible que la constante de temps théorique. Si on relève d'abord le niveau logique bas puis le niveau logique haut, on peut conclure à une constante de temps réelle égale à la constante de temps théorique mais celle-ci peut aussi être trop petite ou trop grande. Il n'est alors pas possible de déterminer l'origine de la défaillance.

Dans le deuxième mode de réalisation, si aux instants de mesure on relève le niveau bas, on peut conclure qu'il y a un court-circuit à la masse ou que la constante de temps réelle est plus petite que la constante de temps théorique. Si on relève, le niveau logique haut, aux deux instants de mesure, on peut conclure à un court-circuit à l'alimentation du premier condensateur ou à une constante de temps réelle plus importante que la constante de temps théorique. Si on relève d'abord le niveau logique haut puis le niveau logique bas, on peut conclure à une constante de temps réelle égale à la constante de temps théorique mais celle-ci peut aussi être trop petite ou trop grande. Il n'est alors pas possible de déterminer l'origine de la défaillance.

On améliore la fiabilité du procédé selon l'invention en choisissant le premier instant de mesure au plus près de l'instant final de pilotage et le deuxième instant de mesure au plus près de l'instant final.

En résumé, dans les procédés selon le premier et le deuxième mode de réalisation, on relève le niveau logique mesuré de la broche d'entrée/sortie 3 à au moins un instant de mesure tMi et on compare les niveaux logiques mesurés LMi aux niveaux logiques théoriques LT(tMi) aux instants de mesure. Si au moins un niveau logique mesuré est différent du niveau logique théorique, la constante de temps théorique est différente de la constante de temps réelle de la ligne, la ligne 5 détecte une défaillance de la ligne. Avantageusement, on mesure le niveau logique de la broche d'entrée/sortie 3 à au moins un instant de mesure auquel on peut définir le niveau logique théorique de la broche, c'est-à-dire en dehors de la plage de temps pendant laquelle la tension de la broche est comprise entre la tension d'entrée minimale de niveau haut et la tension d'entrée maximale de niveau bas.

Avantageusement, la ligne est équipée d'un moyen de correction de la résistance et / ou de la capacité de la ligne pour corriger ces valeurs en fonction de l'écart entre la constante de temps théorique et la constante de temps mesurée.

Avantageusement, la ligne est équipée d'un moyen de correction de la constante de temps de la ligne qui est apte à ajuster les valeurs des capacités et des résistances de la ligne avant de repasser en mode de fonctionnement nominal.

En variante on relève les niveaux logiques de la broche à plus de quatre points de mesure. Cette variante permet de mesurer plus précisément la constante de temps réelle. Cette variante permet en outre de compenser les effets des marges à prendre vis à vis des tolérances des composants (résistance et capacité) de la ligne.

Avantageusement, la ligne est équipée d'un moyen de mémorisation des niveaux logiques mesurés pendant la mise en oeuvre d'un procédé de test et d'un moyen de comparaison des niveaux mesurés à différents stades de la durée de vie de la ligne. On peut alors, en comparant les différents niveaux mesurés en phase opérationnelle et en phase de production, mesurer les marges de tolérance des composantes et les compenser.

Dans un troisième mode de réalisation du procédé selon l'invention, le premier niveau logique de la broche d'entrée/sortie 3 n'est pas connu.

On procède alors, préalablement à la phase de pilotage, à une phase de détermination du premier niveau logique. Avant l'instant initial de pilotage tpi, entre un premier instant initial ti et l'instant initial de pilotage tpi, on procède à une phase d'absence de pilotage lors de laquelle, le générateur de signal 9 ne pilote pas la ligne, il laisse la broche flottante. On mesure le niveau logique de la broche dans son état permanent, le niveau logique mesuré est alors le premier niveau logique. Si le niveau logique mesuré est le niveau logique haut, on applique le procédé selon le premier mode de réalisation, sinon on applique le procédé selon le second mode de réalisation. C'est par exemple le cas d'une ligne selon le premier mode de réalisation où la seconde résistance comprend une résistance de rappel vers le haut de valeur Rp, comme représenté sur la figure 1 et une résistance en série de valeur Rp', disposée en série avec l'élément périphérique 4 et connectée d'une part au câblage 7 et d'autre part au deuxième noeud 22, c'est-à-dire entre le premier noeud 21 et le deuxième noeud 22. La résistance de la ligne individuelle Ri en l'absence de pilotage et de panne de la ligne est donnée par la formule suivante : Ri = Rp + Rp.'

Dans tous les modes de réalisation, il est possible de mesurer, pendant l'étape de mesure, un niveau logique mesuré à un unique instant de mesure et de comparer ce niveau logique mesuré au niveau logique théorique à l'instant de mesure. Une panne est détectée si le niveau logique mesuré est différent du niveau logique théorique.

**Revendications**

1. Procédé de test d'une ligne (5) comprenant une broche d'entrée/sortie (3) d'un circuit logique programmable (2), ladite ligne (5) comprenant au moins une ligne individuelle (1) s'étendant depuis la broche d'entrée/sortie (3) jusqu'à un élément périphérique (4), ladite broche d'entrée/sortie (3) étant apte à être, soit dans un niveau logique haut, soit dans un niveau logique bas opposé au niveau logique haut, ledit procédé comprenant les étapes suivantes :

   - entre un instant initial de pilotage (tpi) et un instant final de pilotage (tpf), une étape de pilotage de la broche d'entrée/sortie (3) dans laquelle on applique une tension de pilotage (UP) aux bornes de la broche d'entrée/sortie (3),

**caractérisé en ce qu'**il comprend en outre les étapes suivantes :

- à partir de l'instant final de pilotage (tpf), une étape de mesure du niveau de la broche d'entrée/sortie (3) pendant laquelle la broche n'est plus pilotée et pendant laquelle on relève un niveau logique mesuré (LMi) de la broche d'entrée/sortie (3) à au moins un instant de mesure (tMi),
- on compare le(s) niveau(x) logique(s) mesuré(s) (LMi) à l' (ou aux) instant(s) de mesure (respectifs) avec le(s) niveau(x) logique(s) théorique(s) dans le(s)quel(s) devrait être la broche d'entrée/sortie (3) à l' (ou aux) instant(s) de mesure (tMi) (respectifs) en l'absence de défaillance de la ligne,
- lorsqu'au moins un niveau logique mesuré à un instant de mesure diffère du niveau logique théorique audit instant de mesure, une défaillance de la ligne est détectée.

2. Procédé de test d'une ligne (5) selon la revendication précédente, **caractérisé en ce qu'**on définit que lorsque la broche d'entrée/sortie (3) n'est pas pilotée :

- elle est dans le niveau logique haut lorsque la tension à ses bornes est supérieure à une tension d'entrée minimale de niveau haut (VIH) et dans le niveau logique bas lorsque la tension à ses bornes est inférieure à une tension d'entrée maximale de niveau bas (VIL),
- lorsqu'elle est en régime permanent c'est-à-dire lorsqu'une tension permanente (Uperm) est appliquée à ses bornes, elle est dans un premier niveau logique (L1) dont la valeur dépend de la valeur de la tension permanente (Uperm),
et **en ce que** on choisit la valeur de la tension de pilotage (UP), appliquée pendant la phase de pilotage du procédé de test, de sorte à mettre la broche dans un deuxième niveau logique (L2), opposé au premier niveau logique (L1),
- lors de la phase de mesure, la ligne (5) forme un circuit RC de sorte que la tension théorique (UBT(t-tpf)) aux bornes de la broche d'entrée/sortie (3) évolue de la tension de pilotage (UP) vers la tension permanente (Uperm) avec une constante de temps théorique d'absence de pilotage (τnp),
- on relève le niveau logique mesuré (LMi) de la broche d'entrée/sortie (3) à au moins un instant de mesure (tMi) auquel la tension théorique de la broche (UBT(tMi-tpf)) n'est pas comprise entre la tension d'entrée maximale de niveau bas (VIL) et la tension d'entrée minimale de niveau haut (VIH).

3. Procédé de test d'une ligne (5) selon la revendication précédente, **caractérisée en ce que** la constante de temps théorique d'absence de pilotage (τnp) du circuit RC est égale au produit de la résistance théorique (R) et de la capacité théorique (C) du circuit RC.

4. Procédé de test d'une ligne (5) selon la revendication précédente, **caractérisé en ce que** la résistance théorique (R) et la capacité théorique (C) du circuit RC sont soit respectivement égales à la résistance et à la capacité de la ligne, en l'absence de pilotage et de défaillance de la ligne, soit respectivement égales à une approximation de ces valeurs.

5. Procédé de test d'une ligne (5) selon l'une quelconque des revendications 2 à 4, **caractérisé en ce qu'**on relève le niveau logique mesuré (LMi) à au moins un instant de mesure auquel le niveau logique théorique est le second niveau logique (L2) et à au moins un instant de mesure auquel le niveau logique théorique est égal au premier niveau logique théorique (L1).

6. Procédé de test d'une ligne 5 selon la revendication précédente, **caractérisé en ce qu'**on relève le niveau logique mesuré (LMi) à au moins deux instants de mesure auxquels le niveau logique théorique est le second niveau logique (L2) et à au moins deux instants de mesure auxquels le niveau logique théorique est égal au premier niveau logique théorique (L1).

7. Procédé de test d'une ligne selon l'une quelconque des revendications 5 à 6, **caractérisé en ce que** lorsque la défaillance est détectée, il comprend en outre une étape d'identification de l'origine de la défaillance en fonction des niveaux logiques mesurés et des niveaux théoriques aux instants de mesure respectifs.

8. Procédé de test d'une ligne selon la revendication 7, **caractérisé en ce qu'**on relève le niveau logique de la broche à un premier instant (tM1) puis à un second instant (tM2) auxquels le niveau logique théorique est le second niveau logique (L2) puis à un troisième instant (tM3) et à un quatrième instant (tM4) auxquels le niveau logique théorique est le premier niveau logique théorique (L1) et, si les niveaux mesurés logiques mesurés évoluent du second niveau logique vers le premier niveau logique avec du retard, respectivement de l'avance, par rapport aux niveaux logiques théoriques, on attribue l'origine de la défaillance au fait que la seconde constante de temps réelle de la ligne est supérieure, respectivement inférieure à la constante de temps théorique de la ligne.

9. Procédé de test d'une ligne selon la revendication 7, **caractérisé en ce qu'**on relève le niveau logique de la broche à un premier instant (tM1) puis à un second instant (tM2) auxquels le niveau logique théorique est le second niveau logique (L2) puis à un troisième instant (tM3) et à un quatrième instant (tM4) auxquels le niveau logique théorique est le premier niveau logique théorique (L1) et :

- lorsque le premier niveau logique (L1) est le niveau logique haut, si aux quatre instants de mesures, on relève le niveau logique haut, on attribue l'origine de la défaillance à un court-circuit vers un potentiel supérieur à la tension d'entrée minimale de niveau haut (VIH),
- lorsque le premier niveau logique (L1) est le niveau logique bas, si aux quatre instants de mesures, le on relève le niveau logique bas, on attribue l'origine de la défaillance à un court-circuit vers un potentiel inférieur à la tension d'entrée maximale de niveau bas (VIL)

10. Procédé de test d'une ligne (5) selon l'une quelconque des revendications 7 à 9, **caractérisé en ce qu'**il comprend en outre une étape de correction de la défaillance.

11. Procédé de test de ligne selon l'une quelconque des revendications 2 à 10, **caractérisé en ce que** le premier niveau logique (L1) est connu.

12. Procédé de test de ligne selon l'une quelconque des revendications 2 à 11, **caractérisé en ce que** préalablement à la phase de pilotage, on procède à une phase de détermination du premier niveau logique (L1) dans laquelle la broche d'entrée/sortie (3) n'est pas pilotée et dans laquelle on mesure le niveau logique de la broche d'entrée/sortie (3), le niveau logique mesuré étant considéré comme étant égal au premier niveau logique (L1).

13. Ligne (5) comprenant une broche d'entrée/sortie (3) d'un circuit logique programmable (2), un contrôleur (8) apte à appliquer une tension de pilotage (UP) aux bornes de la broche d'entrée/sortie (3), **caractérisée en ce que** ladite ligne est apte à mettre en oeuvre le procédé selon l'une quelconque des revendications précédentes et **en ce que** le contrôleur est apte à relever le niveau logique de la broche d'entrée/sortie (3), la ligne comprenant en outre au moins une ligne individuelle (1) s'étendant depuis la broche d'entrée/sortie (3) jusqu'à un élément périphérique (4), ladite ligne individuelle (1) comprenant :

- une première résistance (11), dont la valeur est une valeur de première résistance (Rs), disposée en série avec la broche d'entrée/sortie (3) et connectée, d'une part, à un premier noeud (21) et d'autre part, à la broche d'entrée/sortie (3),
- une première capacité (31), dont la valeur est la valeur de première capacité (Cs), disposée en parallèle avec la broche d'entrée/sortie (3) et connectée, d'une part, au premier noeud (21) et d'autre part, à un potentiel de première capacité (V31),
- un second noeud (22) connecté à l'élément périphérique 4 et à un câblage (7),
- une seconde résistance (12), connectée à un potentiel de deuxième résistance (V12) et au premier noeud (21) par l'intermédiaire du câblage (7),
- une seconde capacité (32) connectée au second noeud (22) et à la masse.

14. Ligne (5) selon la revendication précédente, **caractérisée en ce que** la seconde résistance (12) comprend une résistance de rappel vers le haut, le potentiel de premier condensateur (V31) est nul, le potentiel de deuxième résistance (V12) est supérieur ou égal à la tension d'entrée minimale de niveau haut (VIH) de sorte que le premier état logique (L1) est le niveau haut.

15. Ligne (5) selon la revendication 13, **caractérisée en ce que** la seconde résistance (12) comprend une résistance de rappel vers le bas, le potentiel de premier condensateur (V31) est supérieur ou égal à la tension d'entrée minimale de niveau haut (VIH), le potentiel de deuxième résistance (V12) est nul de sorte que le premier état logique (L1) est le niveau bas.

16. Ligne (5) selon l'une quelconque des revendications 13 à 15, **caractérisée en ce qu'**elle comprend un moyen de détection de l'origine d'une défaillance et éventuellement un moyen de correction de la défaillance.

**Claims**

1. A method for testing a line (5), comprising an input/output pin (3) of a programmable logic circuit (2), said line (5) comprising at least one individual line (1) extending from the input/output pin (3) to a peripheral element (4), said input/output pin (3) being designed to be either on a high logic level or on a low logic level opposite the high logic level, said method comprising the following steps:

   - controlling the input/output pin (3), which step is between an initial controlling instant (tpi) and a final controlling instant (tpf) and in which a control voltage (UP) is applied to the terminals of the input/output pin (3),
   **characterised in that** it further comprises the following steps:
   - measuring the level of the input/output pin (3), on the basis of the final controlling instant (tpf), during which step the pin is no longer controlled and during which a measured logic level (LMi) is recorded from the input/output pin (3) at at least one measuring instant (tMi),
   - comparing the measured logic level(s) (LMi), measured at the one or more respective measuring instants, with the theoretical logic level(s) in which the input/output pin (3) should be found at the one or more respective measuring instants (tMi) in the absence of a fault on the line,
   - detecting a line fault when at least one logic level that is measured at a measuring instant differs from the theoretical logic level at said measuring instant.

2. A method for testing a line (5) according to the preceding claim, **characterised in that** when the input/output pin (3) is not controlled the following is defined:

   - that said input/output pin (3) is on the high logic level when the voltage at its terminals is greater than a minimum high level input voltage (VIH) and it is on the low logic level when the voltage at its terminals is lower than a maximum low level input voltage (VIL),
   - when it is in a steady state, that is when a permanent voltage (Uperm) is applied to its terminals, it is on a first logic level (L1) where the value depends on the value of the permanent voltage (Uperm),
   and **in that** the value of the control voltage (UP), which voltage is applied during the control phase of the test method, is selected so as to place the pin on a second logic level (L2) opposite the first logic level (L1),
   - during the measuring phase, the line (5) forms an RC circuit so that the theoretical voltage (UBT(t-tpf)) at the terminals of the input/output pin (3) changes from the control voltage (UP) to the permanent voltage (Uperm) with a theoretical time constant of the absence of control (τnp),
   - the measured logic level (LMi) of the input/output pin (3) is recorded at at least one measuring instant (tMi) at which the theoretical voltage of the pin (UBT(tMi-tpf)) is not found between the maximum low level input voltage (VIL) and the minimum high level input voltage (VIH).

3. The method for testing a line (5) according to the preceding claim, **characterised in that** the theoretical time constant of the absence of control (τnp) of the RC circuit is equal to the product of the theoretical resistance (R) and of the theoretical capacitance (C) of the RC circuit.

4. The method for testing a line (5) according to the preceding claim, **characterised in that** the theoretical resistance (R) and the theoretical capacitance (C) of the RC circuit are either respectively equal to the resistance and to the capacitance of the line, in the absence of control and a fault on the line, or are respectively equal to an approximation of these values.

5. The method for testing a line (5) according to anyone of claims 2 to 4, **characterised in that** the measured logic level (LMi) is recorded at at least one measuring instant at which the theoretical logic level is the second logic level (L2) and at at least one measuring instant at which the theoretical logic level is equal to the first theoretical logic level (L1).

6. The method for testing a line (5) according to the preceding claim, **characterised in that** the measured logic level (LMi) is recorded at at least two measuring instants at which the theoretical logic level is the second logic level (L2) and at at least two measuring instants at which the theoretical logic level is equal to the first theoretical logic level (L1).

7. The method for testing a line according to anyone of claims 5 to 6, **characterised in that** when the fault is detected it further comprises a step of identifying the source of the fault as a function of the measured logic levels and of the theoretical levels at respective measuring instants.

8. The method for testing a line according to claim 7, **characterised in that** the logic level of the pin is recorded at a first instant (tM1) and then at a second instant (tM2) at which instants the theoretical logic level is the second logic level (L2) and then at a third instant (tM3) and at a fourth instant (tM4) at which instants the theoretical logic level is the first theoretical logic level (L1) and, if the measured logic levels change from the second logic level to the first logic level with a delay, respectively in advance, relative to the theoretical logic levels, the source of the fault is attributed to the fact that the second real time constant of the line is greater respectively smaller than the theoretical time constant of the line.

9. The method for testing a line according to claim 7, **characterised in that** the logic level of the pin is recorded at a first instant (tM1) and then at a second instant (tM2) at which instants the theoretical logic level is the second logic level (L2) and then at a third instant (tM3) and at a fourth instant (tM4) at which instants the theoretical logic level is the first theoretical logic level (L1) and:

   - when the first logic level (L1) is the high logic level, if the high logic level is recorded at the four measuring instants, the source of the fault is attributed to a short-circuit towards a potential that is greater than the minimum input voltage of the high level (VIH),
   - when the first logic level (L1) is the low logic level, if the low logic level is recorded at the four measuring instants, the source of the fault is attributed to a short-circuit towards a potential that is lower than the maximum input voltage of the low-level (VIL).

10. The method for testing a line (5) according to anyone of claims 7 to 9, **characterised in that** it further comprises a step of correcting the fault.

11. The method for testing a line according to anyone of claims 2 to 10, **characterised in that** the first logic level (L1) is known.

12. The method for testing a line according to anyone of claims 2 to 11, **characterised in that** before the control phase, a phase for determining the first logic level (L1) is undertaken in which the input/output pin (3) is not controlled and in which the logic level of the input/output pin (3) is measured, the measured logic level being considered to be equal to the first logic level (L1).

13. A line (5) comprising an input/output pin (3) of a programmable logic circuit (2), a controller (8) designed to apply a control voltage (UP) to the terminals of the input/output pin (3), **characterised in that** said line is designed to implement the method according to any one of the preceding claims and **in that** the controller is designed to record the logic level of the input/output pin (3), the line further comprising at least one individual line (1) extending from the input/output pin (3) to a peripheral element (4), said individual line (1) comprising:

   - a first resistor (11), the value of which is a first resistance value (Rs), arranged in series with the input/output pin (3) and connected on the one hand to a first node (21) and on the other hand to the input/output pin (3),
   - a first capacitor (31), the value of which is the value of the first capacitance (Cs), arranged in parallel with the input/output pin (3) and connected on the one hand to the first node (21) and on the other hand to a potential of the first capacitor (V31),
   - a second node (22) connected to the peripheral element (4) and to wiring (7),
   - a second resistor (12) connected to a potential of second resistance (V12) and to the first node (21) via the wiring (7),
   - a second capacitor (32) connected to the second node (22) and to mass.

14. The line (5) according to the preceding claim, **characterised in that** the second resistor (12) comprises a return resistance in the upwards direction, the potential of the first capacitor (V31) is zero, the potential of the second resistor (V12) is greater than or equal to the minimum high-level input voltage (VIH) so that the first logic state (L1) is the high level.

15. The line (5) according to claim 13, **characterised in that** the second resistor (12) comprises a return resistance in the downwards direction, the potential of the first capacitor (V31) is greater than or equal to the minimum high-level voltage input (VIH), the potential of the second resistor (V12) is zero so that the first logic state (L1) is the low level.

16. The line (5) according to anyone of claims 13 to 15, **characterised in that** it comprises a means for detecting the source of a fault and possibly a means for correcting the fault.

**EP 2 230 528 B1**

**Patentansprüche**

1. Verfahren zum Prüfen einer Leitung (5), die einen Ein-/Ausgangsstift (3) einer programmierbaren Logikschaltung (2) umfasst, wobei die Leitung (5) wenigstens eine individuelle Leitung (1) umfasst, die vom Ein-/Ausgangsstift (3) zu einem peripheren Element (4) verläuft, wobei der Ein-/Ausgangsstift (3) so ausgelegt ist, dass er einen logisch hohen Pegel oder einen logisch tiefen Pegel entgegengesetzt zu dem logisch hohen Pegel hat, wobei das Verfahren die folgenden Schritte beinhaltet:

   - Steuern, zwischen einem ersten Steuerzeitpunkt (tpi) und einem letzten Steuerzeitpunkt (tpf), des Ein-/Ausgangsstifts (3), wobei eine Steuerspannung (UP) an die Anschlüsse des Ein-/Ausgangsstifts (3) angelegt wird, **dadurch gekennzeichnet, dass** es ferner die folgenden Schritte beinhaltet:
   - Messen, ab dem letzten Steuerzeitpunkt (tpf), des Pegels des Ein-/Ausgangsstifts (3), während dessen der Stift nicht mehr gesteuert wird und während dessen ein gemessener Logikpegel (LMi) vom Ein-/Ausgangsstift (3) zu wenigstens einem Messzeitpunkt (tMi) gemessen wird,
   - Vergleichen des/der zu einem oder mehreren (jeweiligen) Messzeitpunkten gemessenen Logikpegel(s) (LMi) mit dem/den theoretischen Logikpegel(n), der/die zu den ein oder mehreren Messzeitpunkten (tMi) in Abwesenheit einer Störung auf der Leitung (jeweils) am Ein-/Ausgangsstift (3) anliegen soll(en),
   - Feststellen einer Leitungsstörung, wenn sich wenigstens ein zu einem Messzeitpunkt gemessener Logikpegel zu dem genannten Messzeitpunkt von dem theoretischen Logikpegel unterscheidet.

2. Verfahren zum Prüfen einer Leitung (5) nach dem vorherigen Anspruch, **dadurch gekennzeichnet, dass** Folgendes definiert wird, wenn der Ein-/Ausgangsstift (3) nicht gesteuert wird:

   - der Ein-/Ausgangsstift (3) ist auf dem logisch hohen Pegel, wenn die Spannung an seinen Anschlüssen höher ist als eine Hochpegel-Mindesteingangsspannung (VIH), und ist auf dem logisch tiefen Pegel, wenn die Spannung an seinen Anschlüssen tiefer ist als eine Tiefpegel-Höchsteingangsspannung (VIL),
   - wenn er im eingeschwungenen Zustand ist, d.h. wenn eine Dauerspannung (Uperm) an seinen Anschlüssen anliegt, ist er auf einem ersten Logikpegel (L1), dessen Wert vom Wert der Dauerspannung (Uperm) abhängig ist, und **dadurch**, dass der Wert der während der Steuerphase des Prüfvorgangs angelegten Steuerspannung (UP) so gewählt wird, dass der Stift auf einen zweiten Logikpegel (L2) entgegengesetzt zu dem ersten Logikpegel (L1) gesetzt wird,
   - die Leitung (5) während der Messphase eine RC-Schaltung bildet, so dass sich die theoretische Spannung (UBT(t-tpf)) an den Anschlüssen des Ein-/Ausgangsstifts (3) von der Steuerspannung (UP) auf die Dauerspannung (Uperm) mit einer theoretischen Zeitkonstante der Abwesenheit von Steuerung (τnp) ändert,
   - der gemessene Logikpegel (LMi) des Ein-/Ausgangsstifts (3) zu wenigstens einem Messzeitpunkt (tMi) gemessen wird, zu dem die theoretische Spannung des Stifts (UBT(tMi-tpf)) nicht zwischen der Tiefpegel-Höchsteingangsspannung (VIL) und der Hochpegel-Mindesteingangsspannung (VIH) liegt.

3. Verfahren zum Prüfen einer Leitung (5) nach dem vorherigen Anspruch, **dadurch gekennzeichnet, dass** die theoretische Zeitkonstante der Abwesenheit von Steuerung (τnp) der RC-Schaltung gleich dem Produkt des theoretischen Widerstands (R) und der theoretischen Kapazität (C) der RC-Schaltung ist.

4. Verfahren zum Prüfen einer Leitung (5) nach dem vorherigen Anspruch, **dadurch gekennzeichnet, dass** der theoretische Widerstand (R) und die theoretische Kapazität (C) der RC-Schaltung jeweils gleich dem Widerstand und der Kapazität der Leitung in Abwesenheit von Steuerung und Störungen auf der Leitung oder jeweils gleich einer Annäherung an diese Werte sind.

5. Verfahren zum Prüfen einer Leitung (5) nach einem der Ansprüche 2 bis 4, **dadurch gekennzeichnet, dass** der gemessene Logikpegel (LMi) zu wenigstens einem Messzeitpunkt, zu dem der theoretische Logikpegel der zweite Logikpegel (L2) ist, und zu wenigstens einem Messzeitpunkt gemessen wird, zu dem der theoretische Logikpegel gleich dem ersten theoretischen Logikpegel (L1) ist.

6. Verfahren zum Prüfen einer Leitung (5) nach dem vorherigen Anspruch, **dadurch gekennzeichnet, dass** der gemessene Logikpegel (LMi) zu wenigstens zwei Messzeitpunkten, zu denen der theoretische Logikpegel der zweite Logikpegel (L2) ist, und zu wenigstens zwei Messzeitpunkten gemessen wird, zu denen der theoretische Logikpegel gleich dem ersten theoretischen Logikpegel (L1) ist.

7. Verfahren zum Prüfen einer Leitung nach einem der Ansprüche 5 bis 6, **dadurch gekennzeichnet, dass** es, wenn die Störung erfasst wird, ferner einen Schritt des Identifizierens der Quelle der Störung in Abhängigkeit von den gemessenen Logikpegeln und den theoretischen Pegeln zu den jeweiligen Messzeitpunkten beinhaltet.

8. Verfahren zum Prüfen einer Leitung nach Anspruch 7, **dadurch gekennzeichnet, dass** der Logikpegel des Stifts zu einem ersten Zeitpunkt (tM1), dann zu einem zweiten Zeitpunkt (tM2) gemessen wird, zu denen der theoretische Logikpegel der zweite Logikpegel (L2) ist, und dann zu einem dritten Zeitpunkt (tM3) und zu einem vierten Zeitpunkt (tM4), zu denen der theoretische Logikpegel der erste theoretische Logikpegel (L1) ist, und, wenn sich die gemessenen Logikpegel vom zweiten Logikpegel zum ersten Logikpegel mit einer Verzögerung, beziehungsweise im Voraus, relativ zu den theoretischen Logikpegeln ändern, die Quelle der Störung auf die Tatsache zurückgeführt wird, dass die zweite Echtzeitkonstante der Leitung größer bzw. kleiner als die theoretische Zeitkonstante der Leitung ist.

9. Verfahren zum Prüfen einer Leitung nach Anspruch 7, **dadurch gekennzeichnet, dass** der Logikpegel des Stifts zu einem ersten Zeitpunkt (tM1) und dann zu einem zweiten Zeitpunkt (tM2) gemessen wird, zu denen der theoretische Logikpegel der zweite Logikpegel (L2) ist, und dann zu einem dritten Zeitpunkt (tM3) und einem vierten Zeitpunkt (tM4), zu denen der theoretische Logikpegel der erste theoretische Logikpegel (L1) ist, und:

   - Zurückführen, wenn der erste Logikpegel (L1) der hohe Logikpegel ist, wenn der hohe Logikpegel zu den vier Messzeitpunkten gemessen wird, der Quelle der Störung auf einen Kurzschluss zu einem Potential, das höher ist als die Hochpegel-Mindesteingangsspannung (VIH),
   - Zurückführen, wenn der erste Logikpegel (L1) der tiefe Logikpegel ist, wenn der tiefe Logikpegel zu den vier Messzeitpunkten gemessen wird, der Quelle der Störung auf einen Kurzschluss zu einem Potential, das tiefer ist als die Tiefpegel-Höchsteingangsspannung (VIL).

10. Verfahren zum Prüfen einer Leitung (5) nach einem der Ansprüche 7 bis 9, **dadurch gekennzeichnet, dass** es ferner einen Schritt des Korrigierens der Störung beinhaltet.

11. Verfahren zum Prüfen einer Leitung nach einem der Ansprüche 2 bis 10, **dadurch gekennzeichnet, dass** der erste Logikpegel (L1) bekannt ist.

12. Verfahren zum Prüfen einer Leitung nach einem der Ansprüche 2 bis 11, **dadurch gekennzeichnet, dass** vor der Steuerphase eine Phase zum Ermitteln des ersten Logikpegels (L1) durchgeführt wird, in der der Ein-/Ausgangsstift (3) nicht gesteuert wird und in der der Logikpegel des Ein-/Ausgangsstifts (3) gemessen wird, wobei der gemessene Logikpegel als gleich dem ersten Logikpegel (L1) angesehen wird.

13. Leitung (5), die einen Ein-/Ausgangsstift (3) einer programmierbaren Logikschaltung (2), eine Steuerung (8) zum Anlegen einer Steuerspannung (UP) an die Anschlüsse des Ein-/Ausgangsstifts (3) umfasst, **dadurch gekennzeichnet, dass** die Leitung so ausgelegt ist, dass sie das Verfahren nach einem der vorherigen Ansprüche ausführt, und **dadurch**, dass die Steuerung so ausgelegt ist, dass sie den Logikpegel des Ein-/Ausgangsstifts (3) misst, wobei die Leitung ferner wenigstens eine individuelle Leitung (1) umfasst, die vom Ein-/Ausgangsstift (3) zu einem peripheren Element (4) verläuft, wobei die individuelle Leitung (1) Folgendes umfasst:

   - einen ersten Widerstand (11), dessen Wert ein erster Widerstandswert (Rs) ist, in Serie mit dem Ein-/Ausgangsstift (3) geschaltet und einerseits mit einem ersten Knoten (21) und andererseits mit dem Ein-/Ausgangsstift (3) verbunden,
   - einen ersten Kondensator (31), dessen Wert der Wert der ersten Kapazität (Cs) ist, parallel mit dem Ein-/Ausgangsstift (3) geschaltet und einerseits mit dem ersten Knoten (21) und andererseits mit einem Potential des ersten Kondensators (V31) verbunden,
   - einen zweiten Knoten (22), der mit dem peripheren Element (4) und mit einem Draht (7) verbunden ist,
   - einen zweiten Widerstand (12), der mit einem Potential eines zweiten Widerstands (V12) und dem ersten Knoten (21) über den Draht (7) verbunden ist,
   - einen zweiten Kondensator (32), der mit dem zweiten Knoten (22) und mit Masse verbunden ist.

14. Leitung (5) nach dem vorherigen Anspruch, **dadurch gekennzeichnet, dass** der zweite Widerstand (12) einen aufwärtigen Rückführungswiderstand umfasst, das Potential des ersten Kondensators (V31) null ist, das Potential des zweiten Widerstands (V12) gleich oder höher als die Hochpegel-Mindesteingangsspannung (VIH) ist, so dass der erste Logikzustand (L1) der hohe Pegel ist.

**15.** Leitung (5) nach Anspruch 13, **dadurch gekennzeichnet, dass** der zweite Widerstand (12) einen abwärtigen Rückführungswiderstand umfasst, das Potential des ersten Kondensators (V31) gleich oder höher als die Hochpegel-Mindesteingangsspannung (VIH) ist, das Potential des zweiten Widerstands (V12) null ist, so dass der erste Logikzustand (L1) der tiefe Pegel ist.

**16.** Leitung (5) nach einem der Ansprüche 13 bis 15, **dadurch gekennzeichnet, dass** sie ein Mittel zum Erkennen der Quelle einer Störung und eventuell Mittel zum Korrigieren der Störung umfasst.

FIG.1a

FIG.2a

FIG.1b

FIG.2b

FIG.3

EP 2 230 528 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7406642 B